(19) **Europäisches Patentamt**

**European Patent Office**

**Office européen des brevets**

(11) **EP 0 902 462 B1**

(12) **EUROPEAN PATENT SPECIFICATION**

(45) Date of publication and mention
of the grant of the patent:
**30.08.2006 Bulletin 2006/35**

(51) Int Cl.:
*H01L 21/3205* (2006.01)

(21) Application number: **97306946.1**

(22) Date of filing: **08.09.1997**

(54) **A method for manufacturing a capacitor lower electrode of a semiconductor memory device**

Verfahren zur Herstellung einer Unterelektrode für eine Halbleiterspeichervorrichtung

Procédé de fabrication d'une électrode inférieure pour un dispositif de mémoire à semiconducteurs

(84) Designated Contracting States:
**DE FR GB NL**

(43) Date of publication of application:
**17.03.1999 Bulletin 1999/11**

(73) Proprietor: **SAMSUNG ELECTRONICS CO., LTD.**
**Suwon City, Kyungki-do (KR)**

(72) Inventors:
• **Nam, Seung-hee**
 **Seocho-gu,**
 **Seoul (KR)**
• **Kim, Young-sun**
 **Yongin-city,**
 **Kyungki-do (KR)**
• **Park, Young-wook**
 **Jangan-gu,**
 **Suwon-city,**
 **Kyungki-do (KR)**

(74) Representative: **Ertl, Nicholas Justin et al**
 **Elkington and Fife LLP,**
 **Prospect House,**
 **8 Pembroke Road**
 **Sevenoaks,**
 **Kent TN13 1XR (GB)**

(56) References cited:
**EP-A- 0 731 491**

**Description**

The present invention relates to a semiconductor device manufacturing method, and more particularly, to a method for manufacturing a capacitor lower electrode of a semiconductor memory device which increases capacitor capacitance by increasing the surface area of the electrode in a dynamic random access memory (DRAM).

In DRAMs, with a decrease in the surface area of a unit memory cell, cell capacitance is reduced, resulting in a lowered reading performance of the memory cell and an increased soft error rate. Therefore, the cell capacitance should be kept at an acceptable level to realize high integration of semiconductor memory devices.

The cell capacitance of a semiconductor memory device is an important factor in determining the memory capacity thereof. Along with the increase in the integration level of semiconductor memory devices, many methods have been suggested for increasing capacitance in a given cell area. The capacitor capacitance C is given by

$$C = \frac{\varepsilon_0 \cdot \varepsilon_r \cdot A}{d}$$

where $\varepsilon_0$ is the dielectric constant of free space, $\varepsilon_r$ is the relative dielectric constant of a dielectric film, A is the effective area of an electrode, and d is the thickness of the dielectric film. As noted from the above equation, the capacitance can be increased by varying three parameters, i.e., the dielectric constant of a dielectric film, the effective area of a capacitor, or the thickness of the dielectric film.

As typical methods for increasing the capacitor capacitance by increasing effective area of an electrode, a hemispherical grain (HSG) silicon film is formed as a rugged surface on the surface of a lower electrode, or a three-dimensional capacitor structure is used, including a stack, a trench, and a cylindrical structure.

Tatsumi discloses in U.S. Patent No. 5,385,863 that, in order to increase the effective area of the capacitor electrode, a capacitance electrode made of a polysilicon film is formed, the polysilicon film being formed by depositing an amorphous silicon film on an insulating film covering a semiconductor substrate, generating a plurality of crystal nuclei at a plurality of the amorphous silicon film, respectively, and growing each of the plurality of crystal nuclei into a mushroom or hemisphere shaped crystal grain to thereby convert the amorphous silicon film into the polysilicon film. However, it is difficult to maintain the face of the amorphous silicon film deposited on the insulating film clean. Even crystallization of a extremely small area in the amorphous silicon film or contamination of the surface of the extremely small area by foreign materials suppresses the surface migration of the silicon atoms in the amorphous silicon film and thus prevents crystal nucleation and growth. As a result, a HSG film of an irregular configuration is produced.

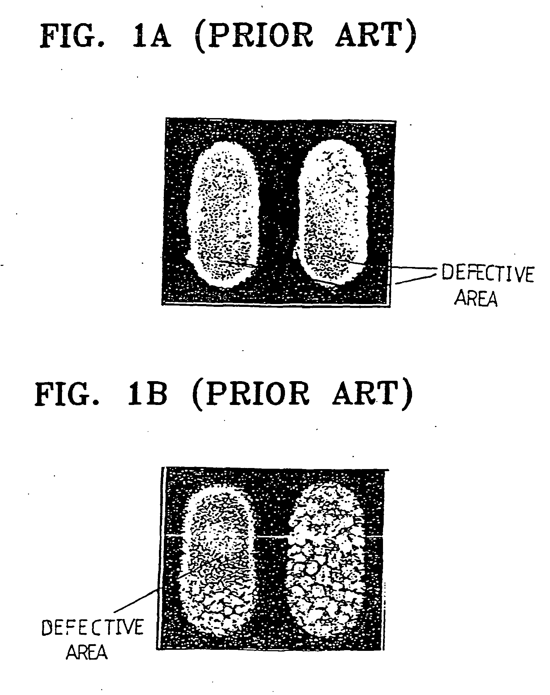

FIGS. 1A and 1B are scanning electron microscope (SEM) photos showing the result of forming HSGs on a partially crystallised amorphous silicon film on a semiconductor substrate. As noted from the figures, HSGs are normally formed on amorphous silicon, while no growth of nuclei is observed in a crystallised portion due to the absence of activation energy of silicon.

Similarly, when the amorphous silicon surface is contaminated by foreign materials and thus the amorphous silicon atoms are combined with foreign atoms, it is difficult for the silicon to make a surface migration, the amorphous silicon surface is further contaminated, and crystal nucleation and growth is terminated if the foreign materials are accumulated to a predetermined thickness.

EP 731491 describes methods of growing HSG films directly on a cleaned amorphous silicon layer using deposition and annealing in a reactor.

According to the present invention, a method for manufacturing a capacitor lower electrode of a semiconductor memory device according to claim 1 is provided.

According to another aspect of the present invention, there is provided a method of forming a capacitor, according to claim 9.

The supply of the predetermined gas is performed while heating the semiconductor substrate, and the step of heating the semiconductor substrate preferably comprises the steps of: (a) maintaining the temperature of the susceptor at 700-1000°C for 5-40 seconds; and (b) maintaining the temperature of the susceptor at 500-800°C in the process chamber, immediately after the step (a).

The predetermined gas is one of $SiH_4$, $Si_2H_6$, $SiH_2Cl_2$, and a mixture thereof. Preferably, the predetermined gas further comprises an inert gas.

The amorphous silicon thin layer is selectively deposited only on the surface of the lower electrode pattern in the step (e).

It is preferable that the step of (e) is performed without vacuum breakdown. The step of growing a plurality of crystal nucleic is performed at a pressure of $10^{-7}$ torr or below.

An example of the present invention will now be described in detail with reference to the accompanying drawings, in which:

FIGS. 1A and 1B are SEM photos showing the result of forming HSGs on a partially crystallized amorphous silicon film on a semiconductor substrate;

FIG. 2 illustrates surface tensions of a crystal nucleus formed on the surface of a lower electrode;

FIGS. 3 through 6 are sectional views sequentially showing the steps in a method for manufacturing a capacitor of a semiconductor memory device according to a preferred embodiment of the present invention;

FIG. 7 illustrates variations of a process temperature in a process chamber in fabricating a capacitor according to the present invention;

FIGS. 8A through 8D are SEM photos showing rugged surface structures obtained by varying the temperature stabilizing time and the process gas supply time;

FIG. 9 is a graph showing the result from an estimation of capacitance and Cmin/Cmax characteristics of samples under each test condition;

FIG. 10 is a graph showing the result from an estimation of capacitance and Cmin/Cmax characteristics with respect to the grain height with a long enough temperature stabilizing time given;

FIG. 11 is a graph showing the result from an estimation of capacitance characteristics of a capacitor manufactured according to the method of the present invention; and

FIG. 12 is a graph showing the result from an estimation of Cmin/Cmax characteristics of the capacitor manufactured according to the method of the present invention.

Generally, the formation of HSG silicon film to increase the effective area of the electrode relies on the mechanism of surface migration of silicon atoms. According to such a mechanism, crystal nuclei are formed on the surface of an amorphous silicon film using a silicon source gas, e.g., silane ($SiH_4$) or disilane ($Si_2H_6$) gas, and annealed so that silicon atoms of the amorphous silicon film migrate to the crystal nuclei and form a HSG silicon film having hemispherical grains of a predetermined size on the surface of the amorphous silicon film. Here, to allow the crystal nuclei to continuously grow for a specified period of time, the migration time of the silicon atoms to the crystal nuclei should exceed the crystallization time of a bulk area of the amorphous silicon film being an underlayer. Therefore, the migration time and the crystallization time should be stably controlled to ensure the increase of the effective area of the electrode by the above mechanism.

The mechanism of forming the HSG silicon film as a rugged surface on the surface of the amorphous silicon film is affected by two factors during processing: the characteristics of the amorphous silicon film itself and contamination caused by foreign materials adsorbed on the surface of the underlayer before or after crystal nucleation.

Specifically, the amorphous silicon film used as an underlayer to form the rugged surface should be kept amorphous and completely free of crystal grains. The possible existence of the crystal grains in the underlayer prevents silicon atoms of the crystal grains from migrating to the crystal nuclei during formation of the rugged surface. On the other hand, foreign material-induced contamination may occur in cleaning the surface of the underlayer or exposing a resultant structure including the crystal nuclei to the atmosphere. Thus, it is essential to keep the surface of the underlayer clean before silicon crystal nucleation.

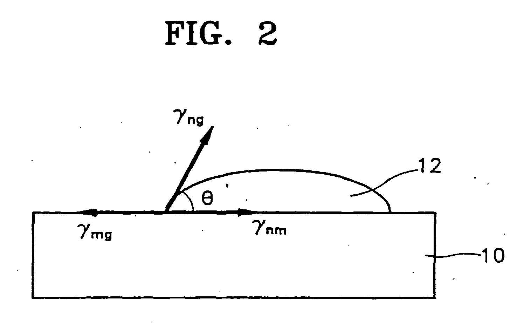

FIG. 2 illustrates a typical crystal nucleus 12 formed of crystal silicon on the surface of a lower amorphous silicon electrode pattern 10 in a gaseous atmosphere.

Generally, the mechanism in which crystal nuclei formed on an amorphous silicon surface grows with phase transition as activation energy can be expressed as the sum of phase transition-related Gibbs free energy and interface energy, i.e., surface energy generated during crystal nucleation and growth. Referring to FIG. 2, such a relationship is given by

$$G = (4/3)\pi r^2 \Delta G_{tr} f(\theta) + 4\pi r^2 \gamma f(\theta)$$

where $\Delta G$ is the total Gibbs free energy, r is the radius of a crystal nucleus, and $\Delta G_{tr}$ is the Gibbs free energy of phase transition per unit volume ($\Delta G_{tr} = \Delta G_{crystal} - \Delta G_{amorphous}$). $\gamma$ is the vector sum of $\gamma_{mg}$, $\gamma_{nm}$, and $\gamma_{ng}$, which are the surface tensions between gas and amorphous silicon, between crystal silicon and amorphous silicon, and between gas and crystal silicon, respectively. $f(\theta)$ is a configuration factor.

As described above, the silicon atoms on the surface of the amorphous silicon migrate to the crystal silicon, that is, the crystal nucleus 12, with activation energy given by the above equation so that crystal nuclei are grown. The above equation represents the minimum activation energy needed for the growth of the silicon atoms in the amorphous silicon film into crystal silicon through the phase-transition to the crystal silicon nucleus. In practice, the silicon atoms of the amorphous silicon film should migrate to the crystal silicon for the growth of the crystal nucleus. To allow the silicon atoms in the amorphous silicon film to migrate to the crystal silicon, the amorphous silicon should be kept in amorphous condition and have a free surface in which silicon atoms are not combined with other atoms.

Embodiment

In the present invention, a semiconductor substrate having an amorphous silicon layer formed thereon is loaded in a process chamber and a thin layer of amorphous silicon of high purity and few defects is formed on the amorphous silicon layer in an ultrahigh vacuum state. Subsequently, crystal nucleation and growth are performed on the amorphous silicon thin layer, thereby forming an intended rugged surface.

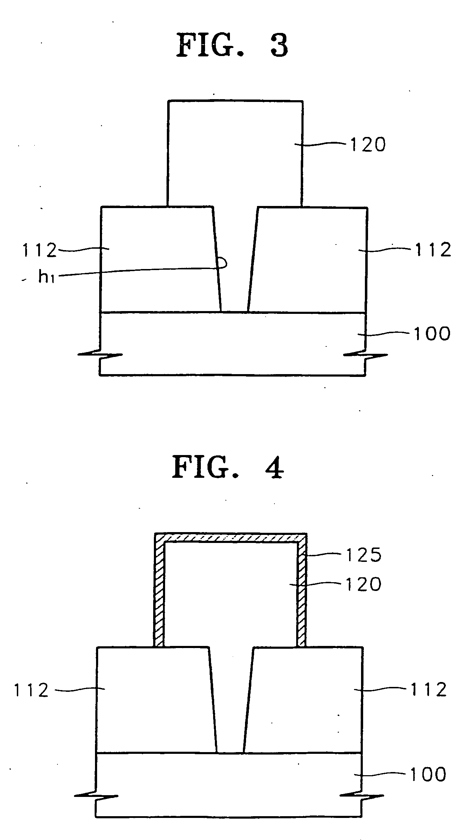

FIGS. 3 through 6 are sectional views sequentially showing the steps in a method for manufacturing a capacitor of a semiconductor memory device according to a preferred embodiment of the present invention.

Referring to FIG. 3, an insulation layer is formed on a semiconductor substrate 100 including an underlying structure such as a transistor to insulate the underlying structure. Then, a photoresist pattern (not shown) is formed on the insulation layer by photolithography. The insulation layer is etched using the photoresist pattern as an etching mask, thereby forming an insulation pattern 112 and a contact hole $h_1$ for exposing a portion of the semiconductor substrate 100.

After the photoresist pattern is removed, an impurity-doped amorphous silicon film is deposited on the overall surface of the resultant structure having the contact hole $h_1$. A lower electrode pattern 120 of amorphous silicon is formed by patterning the deposited amorphous silicon film.

Thereafter, contaminants and a surface oxide film, i.e., a natural oxide film are removed from the surface of the lower electrode pattern 120 by wet-cleaning the resultant. Subsequently, to form a rugged surface, the resultant structure is loaded in the process chamber (not shown) kept in a ultrahigh vacuum state, below or at a pressure of $10^{-7}$ torr (1 torr = 133.3 Pa).

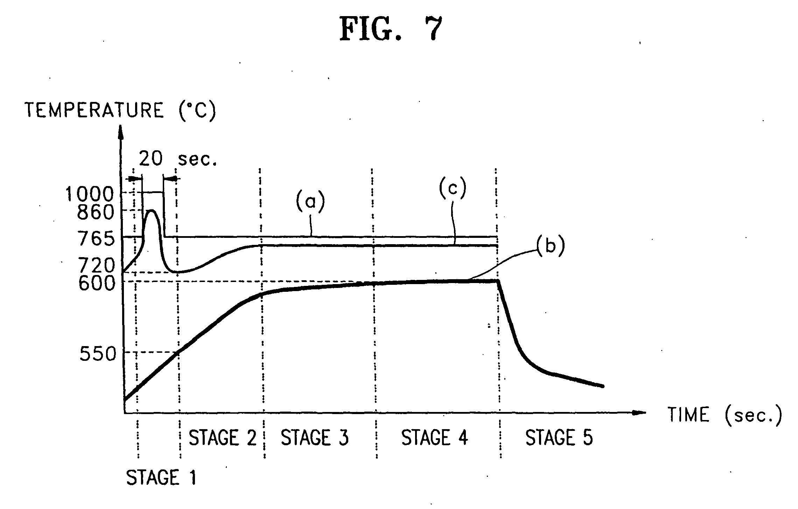

FIG. 7 is a graph showing the temperature variation in each stage during processing in the process chamber to form the rugged surface on the lower electrode pattern 120 of the semiconductor substrate 100. In FIG. 7, reference character (a) indicates a variation in the setting temperature of a heater installed in the chamber to control the temperature of a susceptor in the process chamber. Reference character (b) indicates the variation in semiconductor substrate temperature actually observed. Reference character (c) indicates the variation in susceptor temperature.

Referring to FIG. 7, in stage 1, the susceptor is heated to 700-1000°C, preferably about 850°C, by increasing the heater temperature to approximately 1000°C for about 5-40 seconds, preferably 20 seconds, so as to rapidly increase the temperature of the semiconductor substrate 100 having the lower electrode pattern 120 formed thereon loaded in the process chamber. Then, the susceptor temperature is reduced to a predetermined temperature, for example, 500-800°C, preferably 720°C, by decreasing the heater temperature to about 765°C, and then the heater temperature is maintained at about 765°C. The semiconductor substrate 100 is kept in the process chamber for a predetermined time until the surface of the lower electrode pattern 120 is set at a temperature appropriate for depositing an amorphous silicon thin layer thereon in a subsequent process. Such a standby time, that is, time required to reach a temperature suitable for the deposition of the amorphous silicon thin layer, is referred to as a temperature stabilizing time.

In stage 2 of FIG. 7, when the substrate temperature reaches a predetermined temperature appropriate for the deposition of the amorphous silicon thin layer, that is, lower than a rugged surface forming temperature, the predetermined temperature being 550°C of below, the process chamber is supplied with a process gas needed to form crystal nuclei for rugged surface formation, for example, one of $SiH_4$, $Si_2H_6$, and $SiH_2Cl_2$, so as to deposit the amorphous silicon thin layer on the surface of the lower electrode pattern 120. Here, an inert gas such as nitrogen ($N_2$) or argon (Ar) can be simultaneously supplied into the process chamber.

FIG. 4 illustrates the amorphous silicon thin layer 125 deposited on the surface of the lower electrode pattern 120.

The amorphous silicon thin layer 125 is deposited to a thickness of several tens of angstroms, preferably, only on the surface of the lower electrode pattern 120 by controlling the process gas supply time. Here, since the process chamber is kept at near vacuum conditions of $10^{-3}$torr or below even during the deposition of the amorphous silicon thin layer 125, the adsorption of impurities on the surface of the lower electrode pattern 120 is prevented, thus suppressing contamination of the surface of the semiconductor substrate.

While the amorphous silicon thin layer 125 is being deposited in stage 2 of FIG. 7, the substrate temperature is heated to a temperature of 570°C or above to allow crystal nuclei formation. Thus, a plurality of crystal nuclei can be formed on the surface of the amorphous silicon thin layer 125.

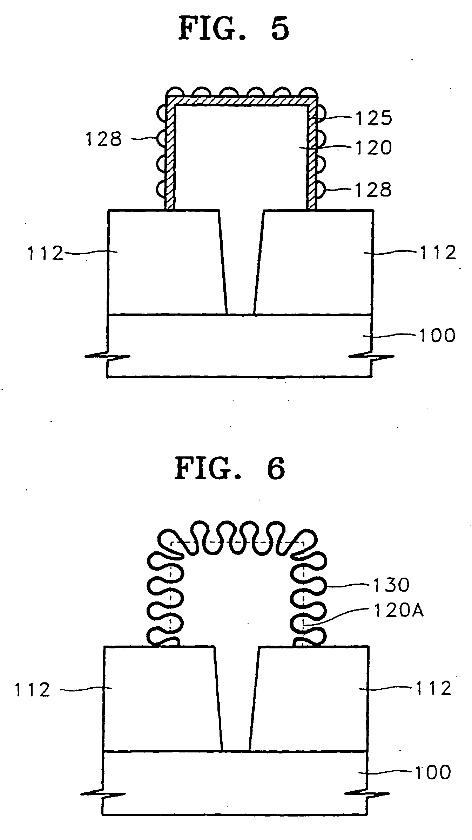

In stage 3 of FIG. 7, as the semiconductor substrate 100 is gradually heated to a crystallization temperature or above, a plurality of crystal nuclei are successively formed on the amorphous silicon thin layer 125 (see FIG. 5). That is, the crystal nuclei are formed on the amorphous silicon thin layer 125 without vacuum breakdown, subsequent to the deposition of the amorphous silicon thin layer 125 in high vacuum. During the silicon crystal nucleation, the aforementioned process gas is continuously provided. When necessary, the flow of gas may be simultaneously controlled. Thus, adsorption and generation of impurities at their interface can be prevented by sequential formation of the amorphous silicon thin layer 125 and the silicon crystal nuclei without vacuum breakdown. Therefore, crystal nuclei of a uniform configuration can be formed in the method of the present invention.

In stage 4 of FIG. 7, supply of the process gas is terminated, and the pressure of the process chamber is maintained again in ultrahigh vacuum, below or at $10^{-7}$Torr, and a process for crystal nuclei growth is performed. That is, as the temperature of the semiconductor substrate 100 reaches a steady-state temperature in the process chamber, crystal nuclei 128 are in effect subjected to heat treatment at the silicon crystallization temperature or above. In practice, it takes approximately 150 seconds for the semiconductor substrate 100 to reach a steady state, i.e., about 600°C in the process chamber. At this time period, silicon atoms in the amorphous silicon thin layer 125 migrate to the crystal nuclei 128 so that crystal nuclei 128 can be grown. If the crystal nuclei continue to grow, mutual cohesion takes place between adjacent crystal grains, resulting in reduction of the effective area of a capacitor. Therefore, the growth of the grains should be controlled by adjusting the heat treatment temperature and time to allow a rugged surface having grains of an appropriate size to be formed.

FIG. 6 is a sectional view of a completed lower electrode 130 having a rugged surface. In FIG. 6, reference numeral 120A indicates the outline of the lower electrode pattern 120 before completing the rugged surface on the lower electrode 130.

After the lower electrode 130 having the rugged surface is completed in stage 4 of FIG. 7, the semiconductor substrate 100 is unloaded from the process chamber and cooled to room temperature.

Then, a capacitor insulation film is formed on the above resultant structure and a conductive material is deposited on the capacitor insulation film to form an upper electrode.

In the present invention, a series of processes for forming the amorphous silicon thin layer on the surface of the lower electrode pattern, forming crystal nuclei and forming the rugged surface are successively performed in the process chamber without vacuum breakdown, thus enabling processing in a highly clean state. Accordingly, the drawbacks encountered in the prior art such as failure of growth of the crystal grains can be overcome and uniformity of crystal grain size and density can be increased. Furthermore, deposition of the amorphous layer between the lower electrode and the rugged surface decreases the ratio of the minimum value to the maximum value of a capacitance (hereinafter, referred to as Cmin/Cmax). This problem can be solved without an additional heat treatment for an ideal Cmin/Cmax, since the semiconductor substrate is subjected to heat treatment in effect in a subsequent process to the formation of a capacitor.

Test 1

The characteristics of a capacitor having a rugged surface on a lower electrode according to the method of the present invention are tested as follows.

To test the effect of formation of an amorphous silicon thin layer on the subsequently formed rugged surface on a lower electrode pattern, a temperature stabilization time, that is, a standby time before supply of a process gas needed to form the amorphous silicon thin layer, was varied from between 30-180 seconds and a process gas supply time was varied from between 80-140 seconds, with the conditions of a heater temperature of 765°C, a crystal nuclei growth time of 180 seconds, and process gas $Si_2H_6$ flow rate of 18sccm kept as they are. Then, the shape of crystal grains forming the rugged surface on the lower electrode was observed.

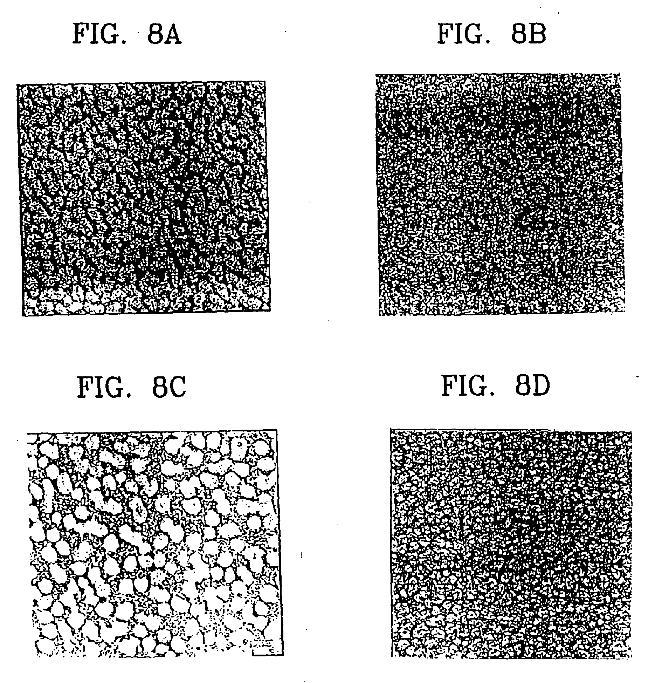

FIGS. 8A through 8D are SEM photos showing the structures of a rugged surface obtained under variations in temperature stabilization time and process gas supply time in the above test. FIG. 8A is for a temperature stabilization time of 180 seconds and a process gas supply time of 80 seconds, FIG. 8B for 90 seconds and 100 seconds, FIG. 8C for 60 seconds and 120 seconds, and FIG. 8D for 30 seconds and 140 seconds, respectively.

As noted from the results of FIGS. 8A through 8D, when crystal nucleation and growth are performed at a silicon crystallization temperature with a long enough temperature stabilization time after a temperature increase (FIG. 8A), the crystal grains are large and very dense. On the other hand, as the temperature stabilization time after the temperature increase is reduced to 90, 60, and 30 seconds, respectively, the amorphous film is deposited before the silicon crystallization temperature is reached after supply of the process gas even though the process gas supply time is increased, leading to a reduction of the time for forming crystal grains. As a result, the structure obtained after the process is completed exhibits low density and small size of crystal grains. Therefore, it is noted that the temperature stabilization time changes the effective area of a lower electrode, thus directly affecting a capacitance value, in fabricating a capacitor.

Test 2

An insulation film and an upper electrode were formed on the sample formed under each condition of Test 1, and then capacitor characteristics were estimated.

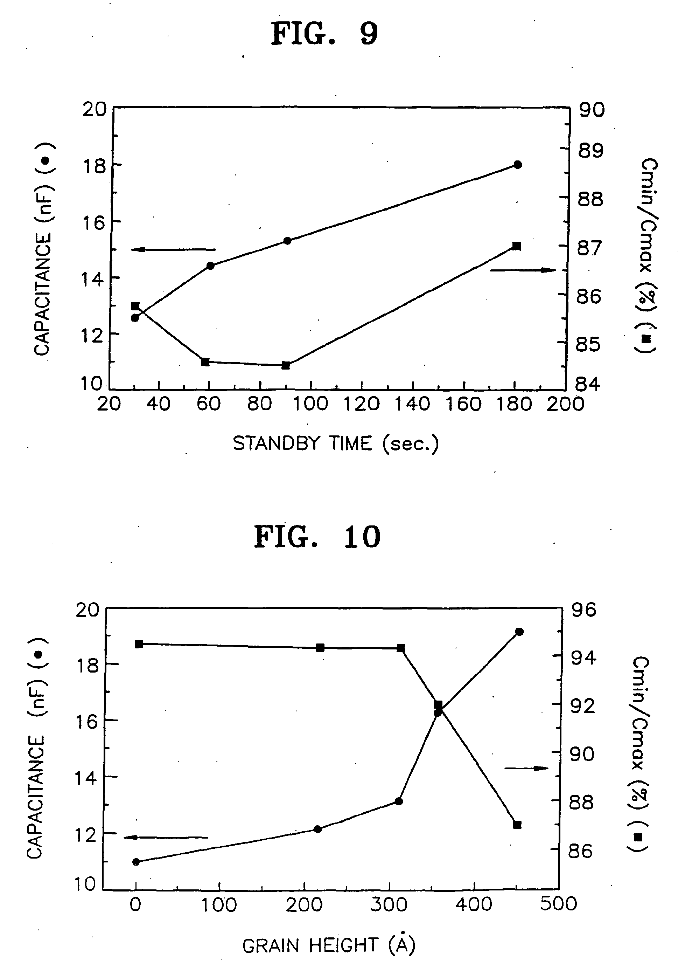

FIG. 9 is a graph showing the result from an estimation of capacitance and Cmin/Cmax characteristics of each sample. Cmin/Cmax is the ratio of the minimum value to the maximum value of capacitance measured by varying a capacitance measuring voltage from -1.5 to +1.5V. Cmin is the capacitance obtained by grounding an n-type impurity-doped lower electrode and applying -1.5V to an upper electrode, while Cmax is the capacitance obtained by grounding the n-type impurity-doped lower electrode and applying +1.5V to the upper electrode.

It is noted from the result of FIG. 9 that the capacitance increases with an increase of the temperature stabilizing time due to an increase in the size and density of crystal grains formed on the surface of the lower electrode, as shown in the SEM photos of FIGS. 8A to 8D. The Cmin/Cmax was also observed to be distributed in the range of 84-87%.

Test 3

Based on the result of Test 2, a semiconductor substrate having an amorphous silicon lower electrode pattern formed thereon is loaded in a process chamber with a long enough temperature stabilization time. Then, characteristics of a capacitor provided with a lower electrode having a rugged surface were estimated according to the method of the present invention. Here, a temperature stabilizing time was 180 seconds, a process gas supply time, i.e., a grain forming time, was 80 seconds, a process gas flow rate was 18sccm, and grain size, that is, grain height was controlled by control of process temperature, in order to estimate capacitance and Cmin/Cmax characteristics according to grain size.

FIG. 10 is a graph showing capacitance and Cmin/Cmax characteristics as a result of the above estimation. In FIG. 10, grain height "0Å" indicates absence of crystal grains forming a rugged surface.

From FIG. 10, it can be seen that the effective area and thus capacitance of the capacitor increase with an increase of grain size. Cmin/Cmax decreases as grain size increases.

As noted from the results, in the capacitor whose effective area is increased by using a rugged surface, capacitance increases and Cmin/Cmax decreases with an increase of grain size.

However, in the case of a capacitor having a rugged surface formed with a short temperature stabilization time according to the method of the present invention, the reduction of grain size increases the capacitance, not Cmin/Cmax, in contrast to the sample of FIG. 10. The reason is that when a silicon forming gas is supplied in high vacuum to form a rugged surface on an amorphous silicon lower electrode pattern doped with impurities, at a low substrate temperature, an amorphous silicon film not doped with impurities is formed before the formation of the rugged surface. Due to the amorphous silicon layer not doped with impurities formed between the lower electrode pattern and the rugged surface, serious depletion takes place in the lower electrode, thus reducing the Cmin/Cmax value.

Here, the problem of the Cmin/Cmax decrease caused by the amorphous silicon layer formed in high vacuum can be solved by a heat treatment after forming a capacitor.

As described above, partial or entire absence of the rugged surface can be prevented and a desired capacitance can be obtained by properly controlling the temperature stabilizing time, process gas supply time, and other process parameters.

Test 4

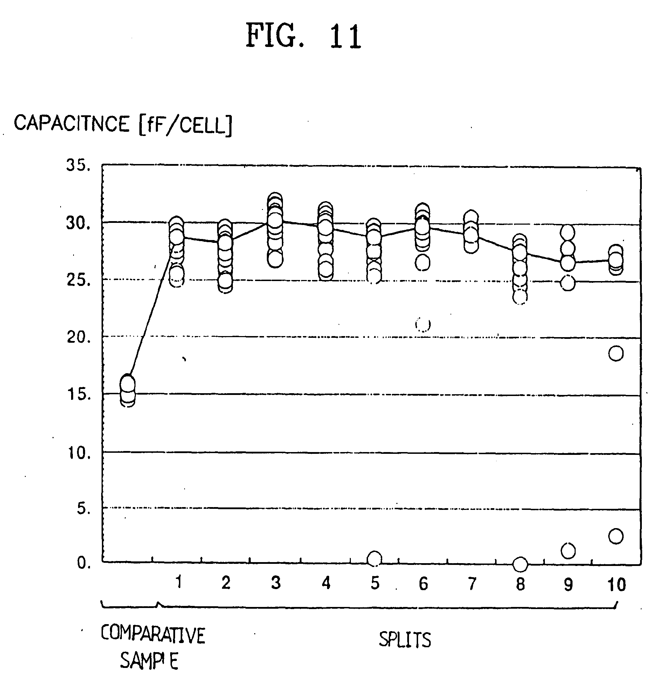

FIG. 11 illustrates the result of a test of capacitance characteristics of a capacitor manufactured according to the method of the present invention. In FIG. 11, a comparative sample, to which the method of the present invention is not applied, has no rugged surface. As noted from the result of FIG. 11, a capacitance of about 25fF/cell of a capacitor manufactured according to the method of the present invention was increased by 1.6 times or more compared with the capacitance of about 15fF/cell of a capacitor to which the method of the present invention is not applied. Further, a reproducible and stable capacitance distribution was obtained according to an application frequency.

Test 5

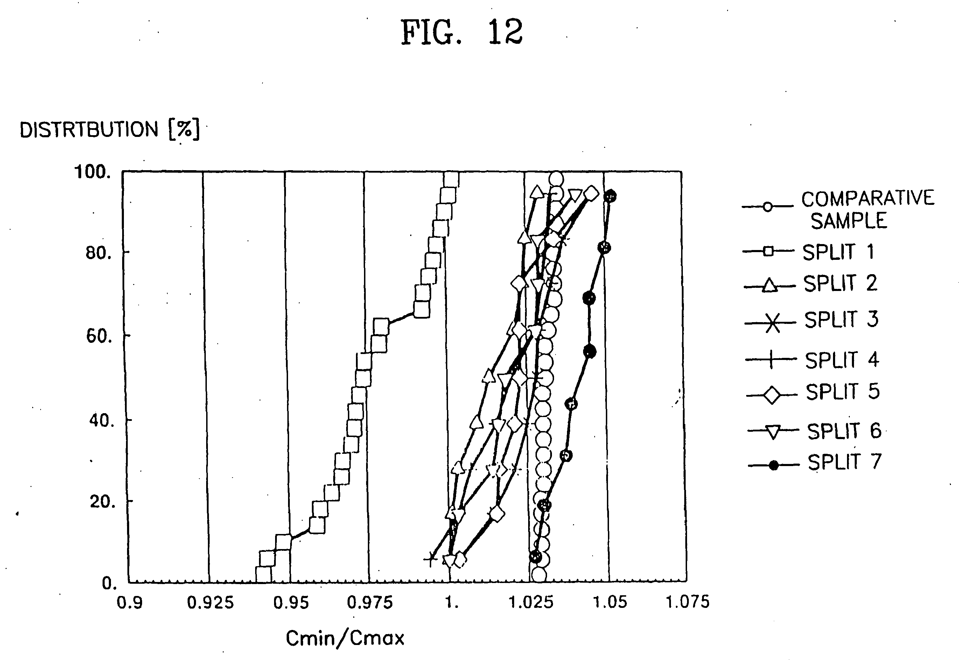

FIG. 12 illustrates the result of a test of Cmin/Cmax characteristics of the capacitor manufacture according to the method of the present invention. In FIG. 12, a comparative example, to which the method of the present invention is not applied, has no rugged surface formed therein. In a practical semiconductor device manufacturing process, a semiconductor substrate is thermally treated in effect without an additional heat treatment since subsequent thermal processes are followed thereafter. Thus, impurity diffusion into an amorphous silicon layer formed in high vacuum can be effected. Therefore, as noted from the result of FIG. 12, Cmin/Cmax characteristics are improved in the capacitor manufactured according to the present invention.

As described above, in the present invention, partial absence of crystal grains can be suppressed, and crystal size and density are increased compared with those of conventional HSGs. Accordingly, the effective area of a capacitor in a semiconductor memory device can be efficiently increased.

**EP 0 902 462 B1**

**Claims**

1.  A method for manufacturing a capacitor lower electrode of a semiconductor memory device, the lower electrode formed by thin film deposition equipment provided within an enclosed process chamber including a susceptor for mounting a wafer thereon, said method comprising the steps of:

    (a) forming an insulation film (112) pattern on a semiconductor substrate, said insulation film having a contact hole ($h_1$) to expose a predetermined area of said semiconductor substrate;
    (b) depositing an impurity-doped amorphous silicon film (120) on the overall surface of the result of step (a);
    (c) forming a lower electrode pattern (120) by patterning said amorphous silicon film;
    (d) removing contaminants and a surface oxide film from the surface of said resultant by cleaning the result of step (c) ;
    (e) loading the cleaned result of step (d) into the process chamber at a pressure of below or at below 1.33 x $10^{-5}$ Pa ($10^{-7}$ Torr) heating the susceptor to heat the substrate;

    waiting for the substrate to reach a temperature of 550°C or below, below a crystallization temperature allowing crystal nuclei formation to occur but suitable for the deposition of an amorphous silicon thin layer; at the temperature of 550°C or below, below the crystallization temperature allowing crystal nuclei formation to occur, supplying a process gas including $SiH_4$, $Si_2H_6$ or $Si H_2 Cl_2$ or a mixture thereof and growing an amorphous silicon thin layer (125) on the surface of the lower electrode pattern (120) at a pressure or 1.33 x $10^{-1}$ Pa or ($10^{-3}$ Torr) or below; while the amorphous silicon layer (125) is being deposited, increasing the substrate temperature to a temperature of 570°C or above, above the crystallization temperature, allowing crystal nuclei to form, and forming crystal nuclei (128) on the amorphous silicon thin layer (125) whilst continuing to provide said process gas; terminating the supply of process gas as the substrate reaches a steady-state temperature and maintaining the substrate at this temperature whilst maintaining the pressure of the process chamber at ultra-high vacumm below 1.33 x $10^{-5}$ Pa ($10^{-7}$ Torr) to grow the plurality of single crystal nuclei (128) to form a rugged surface having grains; and unloading the semiconductor substrate from the process chamber and cooling it to room temperature.

2.  A method for manufacturing a capacitor lower electrode of a semiconductor memory device as claimed in claim 1, wherein said cleaning is performed by a wet cleaning process.

3.  A method for manufacturing a capacitor lower electrode of a semiconductor memory device as claimed in claim 1 or 2, wherein the step of heating the semiconductor substrate comprises the steps of:

    (a) maintaining the temperature of said susceptor at 700-1000°C for 5-40 seconds; and
    (b) maintaining the temperature of said susceptor at 500-800°C in said process chamber; immediately thereafter.

4.  A method for manufacturing a capacitor lower electrode of a semiconductor memory device as claimed in claim 1, wherein said predetermined gas further comprises an inert gas.

5.  A method for manufacturing a capacitor lower electrode of a semiconductor memory device as claimed in any preceding claim, wherein said amorphous silicon thin layer is selectively deposited only on the surface of said lower electrode pattern in said step of (e).

6.  A method for manufacturing a capacitor lower electrode of a semiconductor memory device as claimed in any preceding claim, wherein said steps of (f) and (g) are performed without vacuum breakdown subsequent to said step of (e).

7.  A method for manufacturing a capacitor lower electrode of a semiconductor memory device as claimed in any preceding claim, wherein said steps of (e) to (g) are performed at a ultra high vacuum condition of a pressure of $10^{-7}$torr or below.

8.  A method according to any preceding claim, wherein the amorphous silicon thin layer grown in step (e) is deposited to a thickness of several tens of angstroms.

9.  A method of forming a capacitor, comprising:

    forming a capacitor lower electrode using a method according to any preceding claim;

forming a dielectric layer on the grown silicon nuclei; and

forming a conductive material on the dielectric layer to form an upper electrode.

**Patentansprüche**

1. Verfahren zur Herstellung einer unteren Kondensatorelektrode für eine Halbleiterspeichervorrichtung, wobei die untere Elektrode durch Dünnfilmabscheidungsgerät gebildet wird, das in einer geschlossenen Prozesskammer vorgesehen ist, das einen Suszeptor zum Anbringen eines Wafers darauf aufweist, wobei das Verfahren die Schritte umfasst:

(a) Ausbilden eines Isolationsfilmmusters (112) auf einem Halbleitersubstrat, wobei der Isolationsfilm einen Kontaktdurchtritt ($h_1$) aufweist, um einen bestimmten Bereich des Halbleitersubstrats freizulegen;

(b) Abscheiden eines mit Fremdstoff dotierten amorphen Siliciumfilms (120) auf der gesamten Oberfläche des Produkts von Schritt (a);

(c) Ausbilden eines unteren Elektrodenmusters (120) durch Mustern des amorphen Siliciumfilms;

(d) Entfernen von Verunreinigungen und eines Oberflächenoxidfilms von der Oberfläche des Erhaltenen durch Reinigen des Produkts von Schritt (c);

(e) Einladen des gereinigten Produkts von Schritt (d) in die Prozesskammer bei einem Druck von unter oder bei $1{,}33 \times 10^{-5}$ Pa ($10^{-7}$ Torr) Erwärmen des Halters zum Erwärmen des Substrats;

Abwarten bis das Substrat eine Temperatur von 550 °C oder darunter erreicht hat, unter einer Kristallisationstemperatur, was Kristallkeimbildung ermöglicht, aber geeignet ist für die Abscheidung eines amorphen Siliciumdünnfilms; bei der Temperatur von 550 °C oder darunter, unter der Kristallisationstemperatur, die Kristallkeimbildung ermöglicht, Zuführen eines Prozessgases mit $SiH_4$, $Si_2H_6$ oder $SiH_2Cl_2$ oder einer Mischung davon und Züchten einer amorphen Siliciumdünnschicht (125) auf der Oberfläche des unteren Elektrodenmusters (120) bei einem Druck von $1{,}33 \times 10^{-1}$ Pa ($10^{-3}$ Torr) oder darunter; während die amorphe Siliciumdünnschicht (125) abgeschieden wird, Erhöhen der Substrattemperatur auf eine Temperatur von 570 °C oder darüber, über der Kristallisationstemperatur, was ermöglicht, dass sich Kristallkeime bilden, und Bilden von Kristallkeimen (128) auf der amorphen Siliciumdünnschicht (125), während weiter das Prozessgas zugeführt wird; Beenden der Zufuhr von Prozessgas, wenn das Substrat eine stationäre Zustandstemperatur erreicht und Halten des Substrats bei dieser Temperatur, während der Druck der Prozesskammer auf ultrahohem Vakuum unter $1{,}33 \times 10^{-5}$ Pa ($10^{-7}$ Torr) gehalten wird, um die Mehrzahl von Einkristallkeimen (128) zu züchten, um eine zerklüftete Oberfläche mit Körnern zu bilden; und Entladen des Halbleitersubstrats aus der Prozesskammer und Abkühlen auf Raumtemperatur.

2. Verfahren zur Herstellung einer unteren Kondensatorelektrode für eine Halbleiterspeichervorrichtung nach Anspruch 1, worin das Reinigen durch einen Nassreinigungsprozess durchgeführt wird.

3. Verfahren zur Herstellung einer unteren Kondensatorelektrode für eine Halbleiterspeichervorrichtung nach Anspruch 1 oder 2, worin der Schritt zum Erwärmen des Halbleitersubstrats die Schritte umfasst:

(a) Halten der Temperatur des Suszeptors bei 700-1000 °C für 5-40 Sekunden; und

(b) unmittelbar danach, Halten der Temperatur des Suszeptors bei 500-800 °C in der Prozesskammer.

4. Verfahren zur Herstellung einer unteren Kondensatorelektrode für eine Halbleiterspeichervorrichtung nach Anspruch 1, worin das bestimmte Gas ferner ein Inertgas umfasst.

5. Verfahren zur Herstellung einer unteren Kondensatorelektrode für eine Halbleiterspeichervorrichtung nach einem der vorhergehenden Ansprüche, worin die amorphe Siliciumdünnschicht selektiv nur auf der Oberfläche des unteren Elektrodenmusters in Schritt (e) abgeschieden wird.

6. Verfahren zur Herstellung einer unteren Kondensatorelektrode für eine Halbleiterspeichervorrichtung nach einem der vorhergehenden Ansprüche, worin die Schritte (f) und (g) ohne Vakuumabfall anschließend an den Schritt (e) durchgeführt werden.

7. Verfahren zur Herstellung einer unteren Kondensatorelektrode für eine Halbleiterspeichervorrichtung nach einem der vorhergehenden Ansprüche, worin die Schritte (e) bis (g) bei einem ultrahohen Vakuum mit einem Druck von $10^{-7}$ Torr oder darunter durchgeführt werden.

**8.** Verfahren nach einem der vorhergehenden Ansprüche, worin die in Schritt (e) gezüchtete amorphe Siliciumdünnschicht auf eine Dicke von einigen Dutzend Ångström abgeschieden wird.

**9.** Verfahren zum Ausbilden eines Kondensators, umfassend:

Ausbilden einer unteren Kondensatorelektrode unter Verwendung eines Verfahrens nach einem der vorhergehenden Ansprüche;
Ausbilden einer dielektrischen Schicht auf den gezüchteten Siliciumkeimen; und
Ausbilden eines leitfähigen Materials auf der dielektrischen Schicht zum Ausbilden einer oberen Elektrode.

## Revendications

**1.** Procédé de fabrication d'une électrode inférieure de condensateur pour un dispositif de mémoire à semiconducteurs, l'électrode inférieure formée par un équipement de dépôt de couches minces prévu dans une chambre de processus fermée comprenant un suscepteur destiné à monter une tranche dessus, ledit procédé comprenant les étapes consistant à :

(a) former un motif de film d'isolation (112) sur un substrat à semiconducteurs, ledit film d'isolation possédant un trou de contact ($h_1$) afin d'exposer une zone prédéterminée dudit substrat à semiconducteurs ;
(b) déposer un film de silicium amorphe dopé aux impuretés (120) sur la surface globale du résultat de l'étape (a) ;
(c) former un motif d'électrode inférieure (120) en formant un motif dans ledit film de silicium amorphe ;
(d) retirer les contaminants et un film d'oxyde de surface de la surface dudit résultat en nettoyant le résultat de l'étape (c) ;
(e) charger le résultat nettoyé de l'étape (d) dans la chambre de processus à une pression inférieure à 1,33 x $10^{-5}$ Pa ($10^{-7}$ torr) ; réchauffer le suscepteur afin de chauffer le substrat ; attendre que le substrat atteigne une température de 550°C ou moins, en dessous d'une température de cristallisation permettant la formation de noyaux de cristal, mais convenant pour le dépôt d'une couche mince de silicium amorphe ; à la température de 550°C ou moins, en dessous de la température de cristallisation permettant la formation de noyaux de cristal, fournir un gaz de processus comprenant $SiH_4$, $SiH_6$ ou $SiH_2Cl_2$ ou un mélange de ceux-ci et développer une couche mince de silicium amorphe (125) sur la surface de l'électrode inférieure (120) à une pression de 1,33 x $10^{-1}$ Pa ($10^{-3}$ torr) ou moins ; pendant que la couche de silicium amorphe (125) est déposée, augmenter la température du substrat jusqu'à une température de 570°C ou plus, au-dessus de la température de cristallisation permettant la formation de noyaux de cristal, et former des noyaux de cristal (128) sur la couche mince de silicium amorphe (125) tout en continuant à fournir ledit gaz de processus ; terminer l'alimentation en gaz de processus lorsque le substrat atteint une température stable, et maintenir le substrat à cette température tout en maintenant la pression de la chambre de processus à un vide ultra élevé inférieur à 1,33 x $10^{-5}$ Pa ($10^{-7}$ torr) afin de développer la pluralité de noyaux de cristal (128) de façon à former une surface accidentée possédant des grains ; et décharger le substrat à semiconducteurs de la chambre de processus et le refroidir à température ambiante.

**2.** Procédé de fabrication d'une électrode inférieure de condensateur pour un dispositif de mémoire à semiconducteurs selon la revendication 1, dans lequel ledit nettoyage est effectué par un processus de nettoyage en phase humide.

**3.** Procédé de fabrication d'une électrode inférieure de condensateur pour un dispositif de mémoire à semiconducteurs selon la revendication 1 ou 2, dans lequel l'étape de chauffage du substrat à semiconducteurs comprend les étapes consistant à :

(a) maintenir la température dudit suscepteur à 700 à 1000°C pendant 5 à 40 secondes ; et
(b) maintenir la température dudit suscepteur à 500 à 800°C dans ladite chambre de processus, juste après.

**4.** Procédé de fabrication d'une électrode inférieure pour un dispositif de mémoire à semiconducteurs selon la revendication 1, dans lequel ledit gaz prédéterminé comprend en outre un gaz inerte.

**5.** Procédé de fabrication d'une électrode inférieure pour un dispositif de mémoire à semiconducteurs selon l'une quelconque des revendications précédentes, dans lequel ladite couche mince de silicium amorphe est sélectivement déposée uniquement sur la surface dudit motif d'électrode inférieure à ladite étape (e).

6. Procédé de fabrication d'une électrode inférieure pour un dispositif de mémoire à semiconducteurs selon l'une quelconque des revendications précédentes, dans lequel lesdites étapes (f) et (g) sont effectuées sans coupure de vide après ladite étape (e).

7. Procédé de fabrication d'une électrode inférieure pour un dispositif de mémoire à semiconducteurs selon l'une quelconque des revendications précédentes, dans lequel lesdites étapes (e) à (g) sont effectuées dans une condition de vide ultra élevé d'une pression de $10^{-7}$ torr ou moins.

8. Procédé selon l'une quelconque des revendications précédentes, dans lequel la couche mince de silicium amorphe développée à l'étape (e) est déposée sur une épaisseur de plusieurs dizaines d'angströms.

9. Procédé de formation d'un condensateur, comprenant :

   la formation d'une - électrode inférieure de condensateur en utilisant un procédé selon l'une quelconque des revendications précédentes ;
   la formation d'une couche diélectrique sur les noyaux de silicium développés ;
   et
   la formation d'un matériau conducteur sur la couche diélectrique, afin de former une électrode supérieure.

# FIG. 1A (PRIOR ART)

DEFECTIVE
AREA

# FIG. 1B (PRIOR ART)

DEFECTIVE
AREA

# FIG. 2

# FIG. 3

# FIG. 4

# FIG. 5

128 — 125

120 — 128

112 — 112

100

# FIG. 6

130
120A

112 — 112

100

# FIG. 7

TEMPERATURE (°C)

(a)   (c)

20 sec.

1000
860
765   (b)
720
600

550

TIME (sec.)

STAGE 2 | STAGE 3 | STAGE 4 | STAGE 5

STAGE 1

EP 0 902 462 B1

FIG. 8B

FIG. 8D

FIG. 8A

FIG. 8C

# FIG. 9

# FIG. 10

# FIG. 11

CAPACITNCE [fF/CELL]

COMPARATIVE
SAMPLE

SPLITS

# FIG. 12

DISTRTBUTION [%]

Cmin/Cmax

- ─○─ COMPARATIVE SAMPLE
- ─□─ SPLIT 1
- ─△─ SPLIT 2
- ─✕─ SPLIT 3
- ─+─ SPLIT 4
- ─◇─ SPLIT 5
- ─▽─ SPLIT 6
- ─●─ SPLIT 7

EP 0 902 462 B1